# FASCICULE DE BREVET EUROPEEN

(11) **EP 3 399 563 B1**
(45) Date de publication et mention de la délivrance du brevet: **15.04.2020**
(21) Numéro de dépôt: 18170336.4
(22) Date de dépôt: 02.05.2018
(51) Int. Cl.: H01L 45/00, H01L 27/24

(54) **COMPOSANT SEMI-CONDUCTEUR MÉMOIRE INTÉGRANT UNE NANO-BATTERIE, DISPOSITIF SEMI-CONDUCTEUR COMPRENANT UN TEL COMPOSANT ET PROCÉDÉ UTILISANT UN TEL DISPOSITIF**
HALBLEITERSPEICHERKOMPONENTE, DIE EINE NANOBATTERIE UMFASST, HALBLEITERVORRICHTUNG, DIE EINE SOLCHE KOMPONENTE UMFASST, UND VERFAHREN, BEI DEM DIESE VORRICHTUNG VERWENDET WIRD
MEMORY SEMICONDUCTOR COMPONENT COMPRISING A NANOBATTERY, SEMICONDUCTOR DEVICE COMPRISING SUCH A COMPONENT, AND METHOD USING SUCH A DEVICE

(30) Priorité: 04.05.2017 FR 1753920
(43) Date de publication de la demande: 07.11.2018
(73) Titulaire: Commissariat à l'Energie Atomique et aux Energies Alternatives, 75015 Paris (FR)
(72) Inventeur: LEE, Daeseok, 38100 GRENOBLE (FR); MOLAS, Gabriel, 38000 GRENOBLE (FR); OUKASSI, Sami, 38120 SAINT-EGREVE (FR)
(74) Mandataire: Cabinet Camus Lebkiri

(56) Documents cités:
- US-A1- 2003 048 744
- US-A1- 2013 189 592
- US-A1- 2016 071 565

## Description

### DOMAINE TECHNIQUE DE L'INVENTION

Le domaine technique de l'invention est celui des composants semi-conducteurs. La présente invention concerne un composant semi-conducteur mémoire et en particulier un composant semi-conducteur mémoire auquel est intégré une nano-batterie. L'invention concerne également un dispositif semi-conducteur comprenant un tel composant ainsi qu'un procédé utilisant un tel dispositif.

### ARRIERE-PLAN TECHNOLOGIQUE DE L'INVENTION

L'utilisation de structures verticales pour l'obtention de mémoires denses est une pratique connue de l'homme du métier. Elle a notamment été mise en œuvre avec des mémoires flash comme cela est par exemple décrit dans le document US 2006/0186446.

Plus récemment, une structure similaire a été proposée, mais cette fois-ci en utilisant des mémoires résistives. Cela est notamment détaillé dans le document « Study of Multi-level Characteristics for 3D Vertical Resistive Switching Memory », Scientific Report (2014). Comme illustré en figure 1, ce document décrit un dispositif mémoire comprenant une pluralité de premières électrodes, dite électrodes plane EP, chaque première électrode EP de la pluralité de premières électrodes EP étant séparée des deux électrodes adjacentes EP de la pluralité de premières électrodes EP par une couche d'un matériau isolant CI. Le dispositif comporte également au moins un pilier PI, dit pilier vertical PI, s'étendant essentiellement selon un axe perpendiculaire aux plans définis par les électrodes planes EP, ledit pilier PI comprenant une troisième électrode EV, dite électrode verticale EV et une couche de stockage de l'information CSI, la couche de stockage de l'information CSI recouvrant une surface de l'électrode verticale EV. De plus, dans ce dispositif, chaque électrode plane EP est agencée de sorte à former un point mémoire PM avec le pilier vertical PI. Ainsi, pour chaque pilier PI, on obtient une pluralité de point mémoires PM constituant une cellule mémoire.

Dans un tel dispositif, il est possible d'associer une surface à chaque cellule mémoire. Cependant, seulement une partie de cette surface est effectivement utilisée pour le stockage de l'information et le reste de la surface occupée par une cellule mémoire ne supporte aucune fonctionnalité. De plus, si l'on souhaite adjoindre une batterie à un tel dispositif mémoire, il est nécessaire de produire ladite batterie lors d'étapes supplémentaires sur une autre partie du substrat utilisé pour la fabrication du dispositif mémoire, cette dernière occupant en outre une surface supplémentaire. On trouve aussi des exemples dans les brevets US2003/48744 et US2016/71565.

Certes, il a récemment été démontré, dans l'article de Nature Communications, Valov et AI, 2784, 2013, qu'un effet batterie pouvait être mesuré dans un composant de type mémoire résistive. Cet article décrit qu'un composant de type mémoire résistive, dont le fonctionnement est basé sur l'occurrence de réactions d'oxydoréductions, permet de faire apparaitre une force électromotrice intrinsèque (en anglais « electromotive force ») ou emf provenant de mouvement des ions.

Les auteurs font donc la démonstration expérimentale et théorique de l'existence, dans ce type de composant (ici une mémoire résistive), d'une force électromotrice résultant de la création de différents gradients de potentiels chimiques entre les deux électrodes du composant lorsqu'aucun chemin conducteur de type filament n'est créé entre celles-ci. Cette force électromotrice est considérée comme une tension générée par le composant et peut être obtenue par dissolution d'une électrode active dans la zone active (ici un électrolyte) par un processus électrochimique, c'est ce que les auteurs considèrent comme étant la démonstration d'un effet « nanobatterie».

Toutefois, les auteurs concluent que la force électromotrice observée ne fait que suggérer l'existence d'un effet nano-batterie et propose l'extension des modèles théoriques à même de décrire les phénomènes physiques régissant le fonctionnement des mémoires résistives en intégrant cet effet. L'article ne divulgue donc pas toutes les caractéristiques nécessaires au fonctionnement d'un point mémoire pour le stockage d'énergie et ne décrit pas la faisabilité concrète d'une telle application. En particulier, la force électromotrice n'est mesurée que dans l'état oxydé qui correspondrait uniquement à l'état déchargé d'une batterie. De plus, aucune démonstration de la répétabilité ou de la réversibilité des phénomènes décrits au sein du composant n'est faite. Il est important de noter que la connaissance de cette application (qui ne se déduit aucunement des documents précédemment cités) conduirait à l'utilisation d'une partie des points mémoires comme lieu de stockage de l'énergie sans résoudre le problème de la surface non utilisée.

Il existe donc un besoin d'un dispositif mémoire dont l'ensemble de la surface d'une cellule mémoire est utilisée pour réaliser une fonction. Il existe en outre un besoin d'un tel dispositif permettant d'intégrer facilement une batterie.

### RESUME DE L'INVENTION

L'invention offre une solution aux problèmes évoqués précédemment, en permettant de stocker de l'énergie en utilisant les surfaces non utilisées des dispositifs de l'art antérieur pour réaliser une ou plusieurs zones de stockage de l'énergie de sorte à obtenir une ou plusieurs nano-batteries.

Pour cela, un premier aspect de l'invention concerne un composant semi-conducteur comprenant :
- une première électrode, dite électrode plane, définissant un plan ;
- une deuxième électrode, dite électrode active, séparée de la première électrode par une couche d'électrolyte ;
- un pilier, dit pilier vertical, s'étendant essentiellement selon un axe perpendiculaire au plan défini par l'électrode plane, ledit pilier comprenant une troisième électrode, dite électrode verticale et une couche de stockage de l'information, la couche de stockage de l'information recouvrant une surface de l'électrode verticale ; l'électrode plane et le pilier vertical étant agencés de sorte à former un point mémoire ;

De plus, dans le composant selon l'invention, les matériaux de l'électrode active et de la couche d'électrolyte sont choisis de sorte à former une zone de stockage de l'énergie avec l'électrode plane On entend par électrode active une électrode composée d'un matériau source d'ions et par couche d'électrolyte une couche de matériau isolant au sein de laquelle les ions émis par l'électrode active peuvent diffuser. On entend par matériau source d'ions un matériau comprenant au moins un métal susceptible de libérer des ions métalliques (comme le cuivre qui libère des ions cuivre Cu²⁺) ou un matériau capable de stocker et de restituer des ions (par exemple le silicium).

Grâce à l'invention, il est possible d'intégrer au sein de la surface non utilisée d'un composant mémoire une zone de stockage de l'énergie qui pourra ensuite être utilisée pour alimenter ledit composant ou d'autres composants d'un dispositif auquel ledit composant sera intégré. De plus, la fabrication d'un tel composant nécessite moins d'étapes de fabrication, emploie moins de matériaux et rend l'intégration d'un élément de stockage de l'énergie au sein d'un circuit mémoire plus facile.

Outre les caractéristiques qui viennent d'être évoquées dans le paragraphe précédent, le composant selon un premier aspect de l'invention peut présenter une ou plusieurs caractéristiques complémentaires parmi les suivantes, considérées individuellement ou selon toutes les combinaisons techniquement possibles.

Avantageusement, l'électrode plane comporte un première couche et une deuxième couche, ladite première couche étant en regard de l'électrode active et constituée d'un matériau source d'ions, la deuxième couche et le pilier vertical formant le point mémoire et la première couche, la couche d'électrolyte et l'électrode active formant la zone de stockage de l'énergie.

Ainsi, on obtient une zone de stockage de l'information qui, en plus de la source d'ions que représente l'électrode active, possède une deuxième source d'ions au niveau de la première couche de l'électrode plane.

Avantageusement, le pilier vertical comprend en outre une couche de sélection, ladite couche de sélection étant située entre l'électrode verticale et la couche de stockage de l'information ou sur la couche de stockage de l'information.

Ainsi, les courants de fuite entre l'électrode verticale et l'électrode plane sont limités lors des opérations d'écriture lorsque le point mémoire associé audites électrodes n'est pas sélectionné. Une telle couche est également nommée « back-end selector » dans les dispositifs de l'état de l'art.

Avantageusement, le composant selon l'invention comporte une pluralité d'électrodes planes, une pluralité de couches d'électrolyte et une pluralité d'électrodes actives, chaque électrode plane de la pluralité d'électrodes planes étant agencée de sorte à former un point mémoire avec le pilier vertical. De plus, chaque électrode active de la pluralité d'électrodes actives est séparée d'une électrode plane de la pluralité d'électrodes planes par une couche d'électrolyte de la pluralité de couches d'électrolyte de sorte à former une zone de stockage de l'énergie.

Ainsi, il est possible d'empiler les points mémoires et les zones de stockage de l'information et d'obtenir une pluralité de point mémoire et une pluralité de zone de stockage de l'information par pilier vertical. On accroit ainsi la densité de la mémoire et du stockage de l'énergie par unité de surface du composant.

Avantageusement, chaque électrode plane comporte une troisième couche, ladite troisième couche étant en regard d'une l'électrode active et constituée d'un matériau source d'ions.

Ainsi, lorsque le dispositif comporte une pluralité d'électrode plane et une pluralité d'électrode active, chaque face de chaque électrode active est en regard d'une couche constituée d'un matériau source d'ions.

Avantageusement, la première couche et/ou la troisième couche de l'électrode plane ou de chaque électrode plane ne sont pas en contact avec le pilier vertical. De manière alternative, la première couche et/ou la troisième couche de l'électrode plane ou de chaque électrode plane sont séparées du ou de chaque pilier vertical par un matériau isolant.

Ainsi, lors des opérations d'écriture des points mémoires, on s'assure que le filament formé entre le pilier vertical et l'électrode plane se forme entre la deuxième couche de l'électrode plane et ledit pilier vertical et non pas entre le pilier vertical et la première ou la troisième couche.

Avantageusement, le matériau de l'électrode verticale et le matériau de la couche de stockage de l'information sont choisis de sorte à former, avec l'électrode plane ou avec chaque électrode plane de la pluralité d'électrodes planes, un point mémoire à changement de phase ou un point mémoire résistif. Ainsi, le composant selon l'invention peut être adapté à différents types de mémoire.

Avantageusement, le composant selon l'invention comprend une pluralité de piliers verticaux chaque pilier vertical étant agencé de sorte à former un point mémoire avec l'électrode plane ou avec chaque électrode plane de la pluralité d'électrodes planes. Ainsi, il est possible d'obtenir un plus grand nombre de points mémoires par composant.

Avantageusement, la projection des piliers verticaux de la pluralité de piliers verticaux sur un plan parallèle au plan formé par l'électrode plane ou aux plans formés par les électrodes planes de la pluralité d'électrodes planes forme un réseau dont la maille élémentaire est une maille carrée ou une maille losange.

Ainsi, il est possible de favoriser la fonctionnalité mémoire ou la fonctionnalité stockage de l'énergie en fonction de la disposition des piliers, permettant un degré de liberté supplémentaire lors de la conception d'un composant selon l'invention.

Un deuxième aspect de l'invention concerne un dispositif semi-conducteur comprenant un composant selon un premier aspect de l'invention, ledit dispositif comportant des moyens pour que le composant soit utilisé pour le stockage d'information et/ou pour le stockage d'énergie.

Ainsi, il est possible d'obtenir un dispositif au sein duquel un composant selon un premier aspect de l'invention peut être utilisé comme moyen de stockage de l'énergie et/ou comme moyen de stockage de l'information.

Avantageusement, le dispositif comprend un deuxième composant selon un premier aspect de l'invention et comporte des moyens pour que le deuxième composant soit utilisé pour le stockage d'information et/ou pour le stockage d'énergie.

Ainsi, il est possible d'obtenir un dispositif au sein duquel deux composants selon un premier aspect de l'invention sont utilisés comme moyen de stockage de l'énergie et/ou comme moyen de stockage de l'information. Cette configuration est particulièrement avantageuse si le premier dispositif est adapté pour favoriser le stockage de l'énergie et alimenter en énergie le deuxième dispositif, ce dernier étant alors adapté pour favoriser le stockage de l'information.

Un troisième aspect de l'invention concerne un procédé d'utilisation d'un dispositif selon un deuxième aspect de l'invention comportant :
- une étape dans laquelle au moins un parmi le premier ou le deuxième composant semi-conducteur est utilisé pour le stockage d'information ;
- une étape dans laquelle au moins un parmi le premier ou le deuxième composant semi-conducteur est utilisé pour le stockage de l'énergie.

Ainsi, il est possible d'utiliser l'un des deux composants pour alimenter le deuxième ou bien encore de faire en sorte que chaque composant s'autoalimente.

Avantageusement, l'énergie nécessaire à l'étape d'utilisation d'au moins un composant pour le stockage de l'information est fournie par l'énergie stockée lors de l'étape dans laquelle au moins un composant est utilisé pour le stockage de l'énergie.

Ainsi, le procédé permet de ne pas avoir recours à une source d'énergie extérieure telle qu'une batterie non intégrée au dispositif.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique d'un dispositif mémoire selon l'état de l'art antérieur.
- Les figures 2A à 2D montrent un dispositif semi-conducteur selon un mode de réalisation d'un premier aspect de l'invention.
- Les figure 3A et 3B deux modes de réalisation d'un dispositif semi-conducteur selon un premier aspect de l'invention.
- La figure 4 illustre les notions de distance inter électrodes verticales, de diamètre des piliers verticaux ainsi que de surface d'une cellule mémoire et d'une nano-batterie.
- Les figures 5, 6A et 6B illustrent l'évolution des propriétés d'un composant selon un premier aspect de l'invention en fonction des paramètres dudit composant.
- La figure 7 illustre la notion d'épaisseur dans un composant selon un premier aspect de l'invention.
- Les figures 8A et 8B illustrent l'évolution de l'aspect de forme en fonction du nombre de couches d'électrolyte et de l'épaisseur desdites couches.
- Les figures 9A et 9B illustrent deux dispositions alternatives des piliers verticaux dans un dispositif selon un premier aspect de l'invention.
- Les figures 10 et 11 illustrent deux exemples de réalisation d'un composant selon un premier aspect de l'invention.
- Les figures 12A et 12B illustrent un dispositif selon un deuxième aspect de l'invention ainsi qu'un procédé selon un troisième aspect de l'invention.
- Les figures 13A et 13B illustrent un schéma électrique équivalent d'un composant selon un premier aspect de l'invention.
- Les figures 14A et 14B illustrent les opérations d'initialisation et de réinitialisation des points mémoires d'un composant selon un premier aspect de l'invention.
- Les figures 15A et 15B illustrent les opérations de charge et de décharge des zones de stockage de l'énergie d'un composant selon un premier aspect de l'invention.

### DESCRIPTION DETAILLEE D'AU MOINS UN MODE DE REALISATION DE L'INVENTION

Sauf précision contraire, un même élément apparaissant sur des figures différentes présente une référence unique.

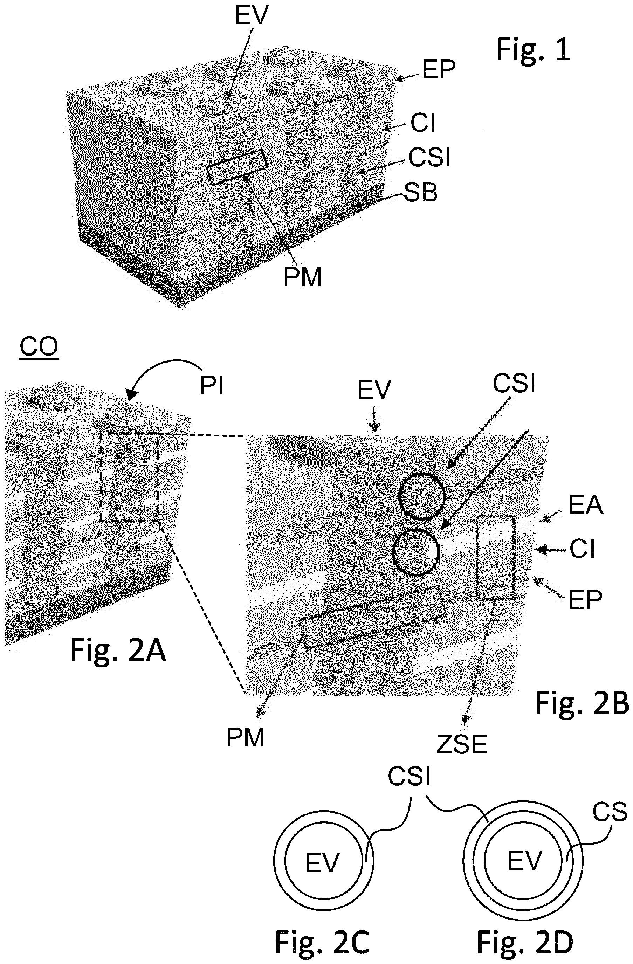

Un premier mode de réalisation selon un premier aspect de la présente invention illustré aux figures 2A, 2B et 2C concerne un composant semi-conducteur comprenant une première électrode, dite électrode plane EP, définissant un plan et une deuxième électrode, dite électrode active EA, séparée de la première électrode par une couche d'électrolyte CI. Il comporte également un pilier PI, dit pilier vertical, s'étendant essentiellement selon un axe perpendiculaire au plan défini par l'électrode plane EP. Comme illustré à la figure 2C qui représente une coupe d'un pilier PI selon un plan perpendiculaire à l'axe principal dudit pilier, ledit pilier PI comprend une troisième électrode, dite électrode verticale EV, et une couche de stockage de l'information CSI, la couche de stockage de l'information CSI recouvrant une surface de l'électrode verticale EV. De plus, l'électrode plane EP, l'électrode active EA et la couche d'électrolyte CI entourent le pilier vertical PI afin que la couche de stockage de l'information CSI, l'électrode verticale EV du pilier vertical PI et l'électrode plane EP soient agencées de sorte à former un point mémoire PM. Le point mémoire PM ainsi obtenu permet de stocker une information par la modification de la résistance de la couche de stockage de l'information CSI, chaque résistance étant associée à un état logique. Cette résistance est modifiée par l'application d'une tension entre l'électrode verticale EV et l'électrode plane EP, autrement dit en appliquant une tension au niveau du point mémoire PM. En fonction des matériaux choisis pour fabriquer l'électrode verticale EV et la couche de stockage de l'information CSI, le point mémoire PM peut être un point mémoire PM à changement de phase ou un point mémoire PM résistif. Par exemple, afin d'obtenir un point mémoire PM résistif, on pourra choisir une couche de stockage de l'information en HfO₂ et une électrode verticale en Ti, une couche de stockage de l'information en Ta₂O₅ et une électrode verticale en Ta, une couche de stockage de l'information en HfO₂ et une électrode verticale en Hf, une couche de stockage de l'information en HfO₂ et une électrode verticale en CuTe, une couche de stockage de l'information en Al₂O₃ et une électrode verticale en Cu ou bien encore une couche de stockage de l'information en Al₂O₃ et une électrode verticale en CuTe. De même, afin d'obtenir un point mémoire à changement de phase, on pourra choisir un couche de stockage de l'information comprenant une couche de GeSbTe et une couche de TiN ainsi qu'une électrode verticale en Cu. Les détails concernant l'enregistrement d'informations au niveau d'un point mémoire PM ou bien encore la nature des matériaux utilisés seront décrits dans la suite.

Dans le composant selon un premier aspect de l'invention, les matériaux composant l'électrode active EA et la couche d'électrolyte CI sont choisis de sorte à former une zone de stockage de l'énergie ZSE avec l'électrode plane EP. On obtient ainsi une zone de stockage de l'énergie ZSE qui peut être chargée et déchargée à l'aide de l'électrode active EA et de l'électrode plane EP. Plus particulièrement, comme cela est évoqué dans l'article Nature Communication précédemment cité, dans un composant électrochimique dont le fonctionnement est basé sur l'occurrence de réactions d'oxydo-réductions et dont l'agencement est de type Electrode active/Couche d'électrolyte/Electrode plane (EA/CI/EP), il est possible d'oxyder l'électrode active EA en appliquant une tension positive alors qu'une réaction de réduction sur la même électrode se produit en appliquant une tension négative. L'oxydation peut entraîner la migration des ions provenant de l'électrode active EA dans la couche d'électrolyte CI ce qui induit une force électromotrice (emf). Cette force électromotrice peut être considérée comme une énergie délivrée par un générateur qui résulte d'un gradient de concentration en ions métalliques (provenant de l'électrode active EA) entre l'électrode active EA et l'électrode plane EP. La force électromotrice de l'état oxydé correspond à l'état déchargé d'une batterie.

Le composant selon l'invention présentée ici implique, au-delà de l'exploitation de la force électromotrice de l'état oxydé, l'exploitation de la force électromotrice de l'état réduit. Réaliser une bascule réversible entre les valeurs de force électromotrice correspondant aux états oxydé et réduit permet d'utiliser la différence de force électromotrice comme source d'énergie. Le passage d'une première valeur de force électromotrice à une seconde valeur de force électromotrice se traduit par un changement d'état de charge au niveau de la zone de stockage de l'énergie ZSE. Cet état de charge est modifié par la migration d'une certaine quantité d'ions d'une électrode vers l'autre à travers la couche d'électrolyte CI et finit par un changement d'état d'oxydation de l'ion en question. Ce mécanisme d'oxydo-réduction est accompagné par un échange électronique, depuis ou vers la zone de stockage de l'énergie ZSE (respectivement étape de décharge ou de charge) et permet ainsi de stocker de l'énergie au sein de ladite zone de stockage de l'énergie ZSE ou de la délivrer, par exemple, à un composant extérieur. Cette énergie prend la forme d'un couple courant/tension. Plus particulièrement, la zone de stockage de l'énergie ZSE se comporte comme une source de tension qui décharge un certain courant, c'est-à-dire qu'il délivre une quantité de charges qui correspond à un courant donné pendant une certaine durée (le temps de décharge). La zone de stockage de l'énergie selon l'invention réalise alors une fonction de stockage d'énergie. Il est important de noter que toute formation de chemin conducteur (tel qu'on en observe dans les mémoires résistives) aurait pour conséquence de court-circuiter la zone de stockages de l'énergie ZSE rendant cette dernière non fonctionnelle. Le fait d'exploiter la bascule entre deux valeurs de force électromotrice pour obtenir la capacité de stocker de l'énergie nécessite donc d'éviter la création d'un tel chemin conducteur, en choisissant notamment des tensions de charge et de décharge appropriées. Afin de permettre les réactions qui viennent d'être détaillées, l'électrode active est donc composée d'un matériau source d'ions et la couche d'électrolyte est une couche d'un matériau isolant au sein de laquelle les ions émis par l'électrode active peuvent diffuser. On comprend de ce qui précède que lorsque l'électrode active EA est composée d'un matériau source d'ions du type 'capable de stocker des ions', alors ledit matériau comporte initialement (c.à.d. avant la première mise en œuvre de la zone de stockage de l'énergie ZSE) des ions stockés en vue du bon fonctionnement de la zone de stockage de l'énergie ZSE. Les détails concernant la charge et/ou la décharge de la zone de stockage de l'énergie ZSE ou bien encore la nature des matériaux utilisés pour réaliser cette dernière seront décrits dans la suite.

La présente invention permet donc de profiter de la surface non utilisée dans les composants de l'art antérieur pour stocker de l'énergie et ainsi obtenir un composant comportant de manière intégrée un point mémoire PM et une zone de stockage de l'énergie ZSE, et ce à l'échelle d'un point mémoire PM (chaque point mémoire PM étant associé à au moins une zone de stockage de l'énergie ZSE).

Dans un mode de réalisation illustré à la figure 2D, afin d'améliorer la sélection des points mémoires PM et de diminuer les courants de fuites, le pilier vertical PI comprend en outre une couche de sélection (ou « backend selector » en anglais), ladite couche de sélection étant située entre l'électrode verticale EV et la couche de stockage de l'information CSI ou sur la couche de stockage de l'information CSI (non illustré). Cette couche de sélection est généralement réalisée dans un oxyde à constante diélectrique élevée (« high-κ oxyde » en anglais).

Dans un exemple de réalisation, l'électrode active est réalisée en LiCoO₂, la couche d'électrolyte est réalisée en LiPON et l'électrode plane est réalisée en platine. Le stockage de l'énergie s'effectue dans la zone de stockage de l'énergie par l'électrodépôt d'ions issus de l'électrode active EA sur l'électrode plane EP, après diffusion à travers la couche d'électrolyte CI.

Dans un mode de réalisation, l'électrode plane EP comporte une première couche EP1 et une deuxième couche EP2, ladite première couche EP1 étant en regard de l'électrode active EA et constituée d'un matériau, la deuxième couche EP2 et le pilier vertical PI formant le point mémoire PM et la première couche EP1, la couche d'électrolyte CI et l'électrode active EA formant la zone de stockage de l'énergie ZSE. Dans un exemple de réalisation, l'électrode active EA est réalisée en LiCoO2, la couche d'électrolyte est réalisée en LiPON, la première couche EP1 de l'électrode plane EP est réalisée en Si et la deuxième couche EP2 de l'électrode plane EP est réalisée en Pt. Le stockage de l'énergie s'effectue dans la zone de stockage ZSE de l'énergie par la migration d'ions depuis l'électrode active EA vers la première couche EP1 de l'électrode plane EP. Dans le cas où une zone de stockage de l'énergie ZSE comprend deux sources d'ions, il importe seulement que l'une des deux soit en mesure de fournir des ions lors de la première mise en œuvre de la zone de stockage de l'énergie ZSE. Ainsi, si la zone de stockage de l'énergie ZSE comprend au moins une source d'ions de type 'capable de stocker des ions', alors cette source d'ions peu initialement (c.à.d. avant la première mise en œuvre de la zone de stockage de l'énergie) ne comporter aucun ion pour peu que la deuxième source d'ions en comporte. Dans l'exemple ci-dessus, la première couche EP1 de l'électrode plane EP est constituée d'un matériau source d'ions de type 'capable de stocker des ions' : le silicium. Initialement, ce silicium peut ne comporter aucun ion, les ions nécessaires au bon fonctionnement de la zone de stockage de l'énergie ZSE étant apportés par l'électrode active EA composée également d'un matériau source d'ions : le LiCoO₂ qui est susceptible de fournir des ions Lithium. Quoiqu'il en soit, un fois la zone de stockage de l'énergie ZSE mise en œuvre, des ions Li⁺ seront également présents dans la première couche EP1 de l'électrode plane EP.

Dans un mode de réalisation, afin de s'assurer que le filament entre l'électrode plane EP et l'électrode verticale EV se forme au niveau de la deuxième EP2 couche, la première couche EP est dix fois moins conductrice que la deuxième couche EP2, voire cent fois moins conductrice que la deuxième couche EP2. Dans un mode de réalisation alternatif ou complémentaire, la première couche EP1 n'est pas en contact avec le pilier vertical PI. Une telle configuration peut être obtenue par un procédé de gravure sélective. Par exemple, si la première couche EP1 de l'électrode plane EP est en aluminium et la deuxième couche EP2 de l'électrode plane EP est en platine, alors une gravure humide à base de H₃PO₄ gravera la première couche EP1 sans graver la deuxième couche EP2 de sorte que lorsque le pilier vertical PI est ensuite formé, un vide est obtenu entre le pilier vertical PI et la première couche EP1. Dans un mode de réalisation alternatif, la première couche EP1 de l'électrode plane EP est séparée du pilier vertical PI par un matériau isolant. Pour cela, après la gravure humide sélective décrite plus haut et avant la formation du pilier vertical PI, une étape de dépôt conforme d'un isolant est effectué sur la face de l'électrode plane EP destinée à être en regarde avec le pilier vertical PI puis une étape de gravure anisotrope est effectuée de sorte à ce qu'il ne reste qu'une couche d'oxyde au niveau de la première couche EP1. Ainsi, une fois le pilier vertical formé, ce dernier est séparé de la première couche de l'électrode plane par une couche d'isolant prévenant la formation d'un filament entre ladite première couche et l'électrode verticale dudit pilier.

Dans un mode de réalisation, le composant comporte une pluralité d'électrodes planes EP, une pluralité de couches d'électrolyte CI et une pluralité d'électrodes actives EA. De plus, chaque électrode plane EA de la pluralité d'électrodes planes EA est agencée de sorte à former un point mémoire PM avec la couche de stockage de l'information CSI et l'électrode verticale EV du pilier vertical PI. En outre, chaque électrode active EA de la pluralité d'électrodes actives EA est séparée de chaque l'électrode plane EP adjacente de la pluralité d'électrodes planes EP par une couche d'électrolyte CI de la pluralité de couches d'électrolyte CI de sorte à former une zone de stockage de l'énergie ZSE. Ainsi, on obtient une cellule mémoire CM comprenant un empilement de plusieurs points mémoires PM, mais également un empilement de plusieurs zones de stockage de l'énergie ZSE formant une nano-batterie NB. Dans la suite, une cellule mémoire CM désigne l'ensemble comportant les points mémoires PM ainsi que la nano-batterie NB. Autrement dit, la nano-batterie NB est comprise dans la cellule mémoire CM.

Dans un mode particulièrement avantageux, le nombre d'électrodes planes EP est égal à n (n étant un entier) et le nombre d'électrodes actives EA est égal à n+1. Autrement dit, une électrode active EA peut former au niveau de sa première surface une première zone de stockage de l'énergie ZCE avec la couche d'électrolyte CI et l'électrode plane EP en regard de ladite première surface ainsi qu'une deuxième zone de stockage de l'énergie ZCE avec la couche d'électrolyte CI et l'électrode plane EP en regarde de la deuxième surface de ladite électrode active EA. Ainsi, le dispositif selon un premier aspect de l'invention comprend, pour chaque point mémoire PM, deux zones de stockage de l'énergie ZSE.

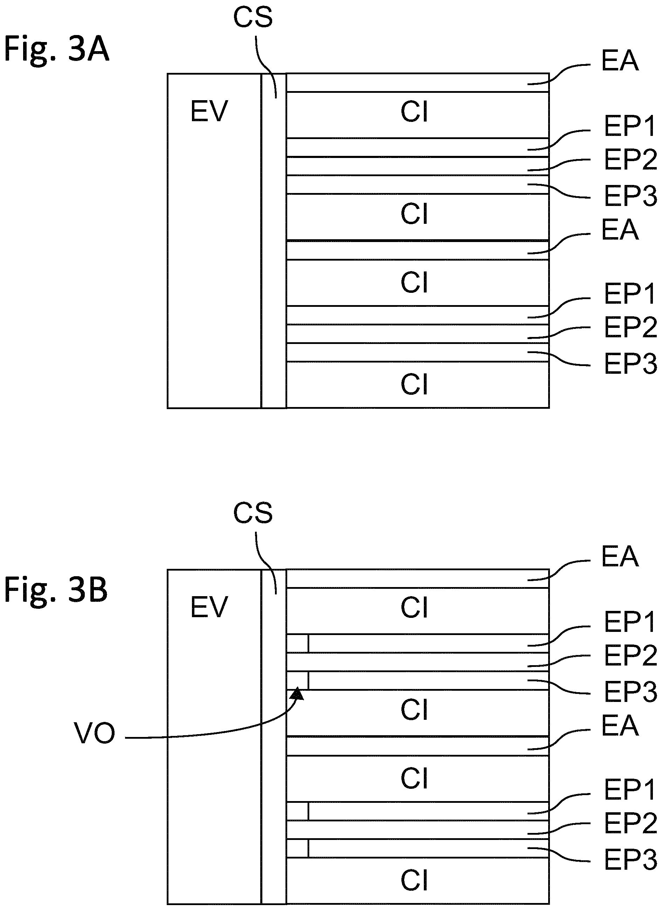

Dans un mode de réalisation illustré à la figure 3A, chaque électrode plane EP comporte une troisième couche EP3, ladite troisième couche EP3 étant en regard d'une électrode active EA et constituée d'un matériau source d'ions. Ainsi, chaque électrode plane EP de la pluralité d'électrodes planes EP comporte une première couche EP1 en matériau source d'ions séparé d'une première électrode active EA de la pluralité d'électrode active par une première couche d'électrolyte CI de la pluralité de couches d'électrolyte CI, une deuxième couche EP2 formant le point mémoire PM avec le pilier vertical PI et une troisième couche EP3 en un matériau source d'ions séparée d'une deuxième électrode active EA de la pluralité d'électrodes actives EA par une deuxième couche d'électrolyte CI de la pluralité de couches d'électrolyte CI. Comme décrit précédemment, il est important d'éviter la formation d'un filament entre le pilier vertical PI et la première couche EP1 ou de la troisième couche EP3. Pour cela, dans un mode de réalisation, la première couche EP1 et la troisième couche EP3 sont dix fois moins conductrices que la deuxième couche conductrice EP2, voire cent fois moins conductrices que la deuxième couche EP2. Dans un mode de réalisation alternatif ou complémentaire illustré à la figure 3B, la première couche EP1 et/ou la troisième couche EP3 de chaque électrode plane EP sont séparées du pilier vertical PI par un espace VO, autrement dit, elles ne sont pas en contact avec le pilier vertical PI. De manière alternative, la première couche EP1 et/ou la troisième couche EP3 de chaque électrode plane EP sont séparées du ou de chaque pilier vertical PI par un matériau isolant. Ainsi, lors des opérations d'écriture des points mémoires PM, on s'assure que le filament formé entre le pilier vertical PI et l'électrode plane EP se forme entre la deuxième couche EP2 de ladite électrode plane EP et ledit pilier vertical PI. Des exemples de procédés permettant de parvenir à de telles configurations, par ailleurs connus de l'homme du métier, ont été donnés précédemment et ne seront donc pas répétés ici.

Dans un mode de réalisation, un composant selon un premier aspect de l'invention comprend une pluralité de piliers verticaux PI, chaque pilier vertical PI étant agencé de sorte à former un point mémoire PM avec chaque électrode plane EP. Il est ainsi possible d'obtenir un composant comportant une pluralité de cellule mémoire CM (et donc de nano-batteries NB) chaque cellule mémoire CM comportant un ou plusieurs points mémoire PM (et donc chaque nano-batterie NB comprenant une ou plusieurs zones de stockage de l'énergie ZSE).

Dans un mode de réalisation, l'électrode verticale EV est de forme cylindrique et comprend une première et une deuxième surface parallèle l'une à l'autre ainsi qu'une troisième surface, dite surface latérale ou surface cylindrique. Dans ce mode de réalisation, la couche de stockage de l'information CSI recouvre la surface latérale de l'électrode verticale EV. Dans un mode de réalisation, le cylindre est un cylindre circulaire droit. Pour mémoire, un cylindre est une surface réglée dont les génératrices sont parallèles, c'est-à-dire une surface dans l'espace, dite surface cylindrique, constituée de droites parallèles. Par extension, on appelle encore cylindre le solide délimité par une surface cylindrique et par deux plans strictement parallèles. Si ces plans sont perpendiculaires aux génératrices, on dit que le cylindre est droit.

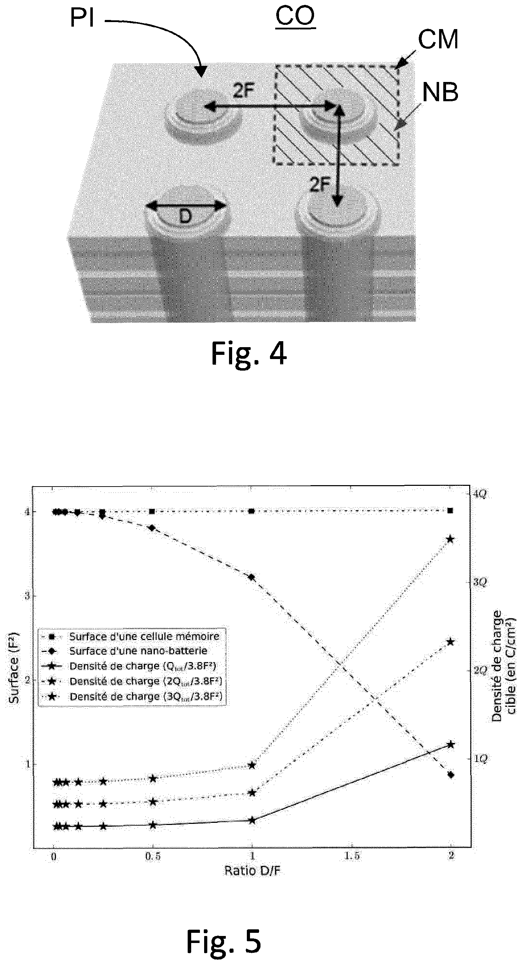

Comme illustré en figure 4, il est possible de définir une unité de surface de la cellule mémoire CM ainsi qu'une unité de surface de la nano-batterie NB (qui correspond à la surface de la cellule mémoire CM moins la surface occupée par le pilier vertical PI). De plus, le pilier vertical PI définit un cylindre de diamètre D, chaque cylindre de la pluralité de cylindres étant distant du cylindre suivant d'une distance 2F, ladite distance étant mesurée entre les axes de révolution desdits cylindres. A partir de ces deux paramètres, il est possible de définir la surface d'une cellule mémoire CM comme étant égale à 4F² et la surface de la nano-batterie NB comme étant égale à 4F²-πD²/4.

Comme illustré à la figure 5, il est possible de faire varier ces deux paramètres en fonction de la fonctionnalité (stockage de l'information ou stockage de l'énergie) que l'on souhaite privilégier. Sur cette figure est représentée la densité de charge correspondant à trois objectifs de charge (Qtot, 2Qtot et 3Qtot) par zone de stockage de l'énergie ZSE, la surface de la cellule mémoire CM et la surface de la nano-batterie NB en fonction du ratio D/F. Les configurations correspondant à des points situés sur la droite du graphique minimisent la surface de la nano-batterie NB (et donc de la ou des zones de stockage de l'énergie ZSE) et sont donc des configurations plus favorables au stockage de l'information comparativement aux configurations correspondant à des points sur la gauche du graphique qui tendent à maximiser la surface de la nano-batterie NB. Comme nous allons maintenant le voir, ces paramètres peuvent être modulés de différentes manières.

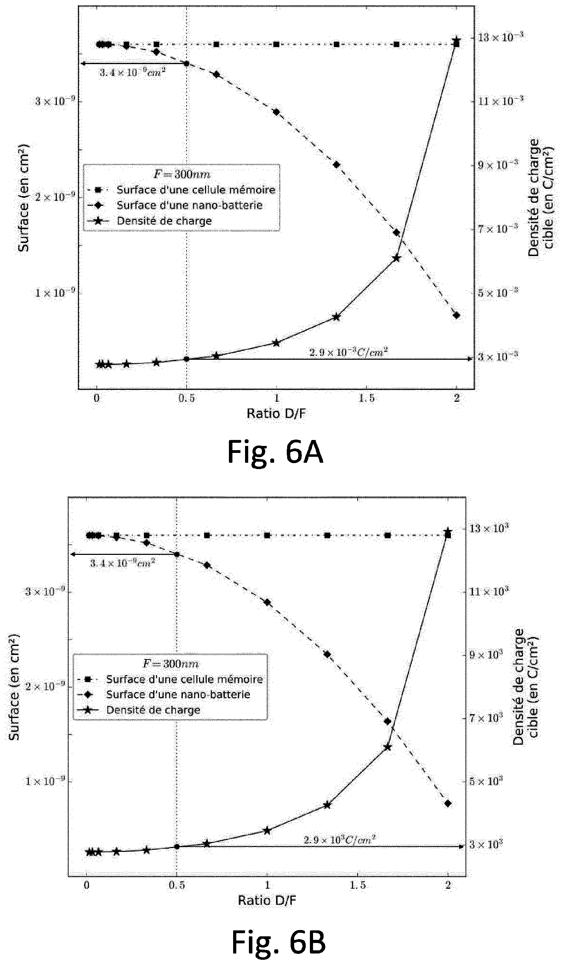

Lorsque la distance inter piliers verticaux 2F est fixe (autrement dit, la densité de cellules mémoires CM par unité de surface est fixée), il est possible de varier le diamètre D desdits piliers verticaux PI afin d'adapter la géométrie du composant en fonction des besoins, par exemple en termes de stockage de l'énergie. Les figures 6A et 6B représentent la surface d'une cellule mémoire CM, la surface d'une nano-batterie NB ainsi que la densité de charge nécessaire à une (figure 6A) ou plusieurs (figure 6B) opérations d'initialisation ou de réinitialisation sur un point mémoire PM en fonction du ratio D/F pour un composant dont la distance inter piliers F est égale à 300 nm. La densité de charge cible est définie par Qtot/(surface d'une nano-batterie NB) où Qtot est la charge totale cible à stocker dans chaque zone de stockage de l'énergie ZSE d'une nano batterie NB. Comme détaillé précédemment, chaque point mémoire PM est associé à au moins une zone de stockage de l'énergie ZSE. Dans la configuration avantageuse comprenant une pluralité d'électrodes planes EP et une pluralité d'électrodes actives EA, chaque point mémoire PM peut être associé à deux zones de stockage de l'énergie ZSE. Dans la suite, la configuration considérée est celle dans laquelle chaque point mémoire PM est associé à deux zones de stockage de l'énergie ZSE.

Dans la figure 6A, l'énergie à stocker dans chaque zone de stockage de l'énergie ZSE est fixée en fonction d'un objectif consistant à pouvoir effectuer deux opérations d'initialisation ou de réinitialisation d'un point mémoire PM, ce qui correspond dans notre exemple à la charge électrique Qtot nécessaire pour produire un pulse de 100µA pendant 100ns soit Qₜₒₜ=10pC (on suppose ici que chaque point mémoire PM est associé à deux zones de stockage de l'énergie ZSE). En traçant la densité de charge cible en fonction du ratio D/F comme cela est fait sur la figure 6A, il est possible de choisir un diamètre D, en fonction de la densité de charge souhaitée. Dans l'exemple de la figure 6A, une densité de charge souhaitée égale à 2.9mC/cm² correspond à une surface de nano-batterie NB de 3.4x10⁻⁹cm², c'est-à-dire un diamètre D de 150nm. Il est donc possible de déterminer le diamètre D en fonction de la densité de charge souhaitée.

Dans la figure 6B, l'énergie à stocker dans chaque zone de stockage de l'énergie ZSE est fixée en fonction d'un objectif consistant à pouvoir effectuer 2x10⁶ opérations d'initialisation ou de réinitialisation d'un point mémoire PM, ce qui correspond dans notre exemple à la charge électrique Qtot nécessaire pour produire 10⁶ pulses de 100µA pendant 100ns soit Qₜₒₜ=10µC (on suppose également ici que chaque point mémoire PM est associé à deux zones de stockage de l'énergie ZSE). En traçant la densité de charge cible en fonction du ratio D/F comme cela est fait sur la figure 6B, il est possible de déterminer le diamètre D en fonction de la densité de charge souhaitée. Dans l'exemple de la figure 6B, une densité de charge souhaitée égale à 2.9x10³C/cm² correspond à une surface de nano-batterie NB de 3.4x10⁻⁹cm², c'est-à-dire un diamètre D de 150nm. Les résultats précédents sont résumés dans le tableau 1 ci-dessous.

**Tableau 1**

| **Exemple** | **Deux cycles mémoires** | **2x10⁶ cycles mémoires** |
|---|---|---|
| **F** | 300nm | 300nm |
| **D** | 150nm | 150nm |
| **Surface de la nano-batterie** | 3.4x10⁻⁹cm² | 3.4x10⁻⁹cm² |
| **Qₜₒₜ** | 10pC | 10uC |
| **Densité de charge souhaitée** | 2.9mC/cm² | 2.9x10³C/cm² |

Il est également possible, pour un diamètre D des piliers verticaux PI donné, de faire varier la distance inter électrodes F. Par exemple, un objectif consistant à pouvoir effectuer deux opérations d'initialisation ou de réinitialisation d'un point mémoire PM (soit la charge électrique Qtot par zone de stockage de l'énergie ZSE nécessaire pour produire un pulse de 100µA pendant 100ns soit Qₜₒₜ=10pC) avec un diamètre D fixé à 300nm et une densité de charge souhaitée égale à 73mC/cm² est obtenue avec une distance F entre électrodes verticales EV de 600nm. Il est bien entendu possible de réduire le diamètre D pour diminuer la densité de charge nécessaire pour atteindre l'objectif en termes d'énergie stockée. Cependant, comme cela sera décrit dans la suite, le diamètre D ne peut pas être réduit indéfiniment du fait de contraintes de fabrication, notamment en termes de facteur de forme. Le diamètre D est donc compris entre une valeur haute égale à 2F pour laquelle la surface dédiée au stockage de l'énergie est minimale et une valeur basse fixée par les limites de fabrication pour laquelle la surface dédiée au stockage de l'énergie est maximale.

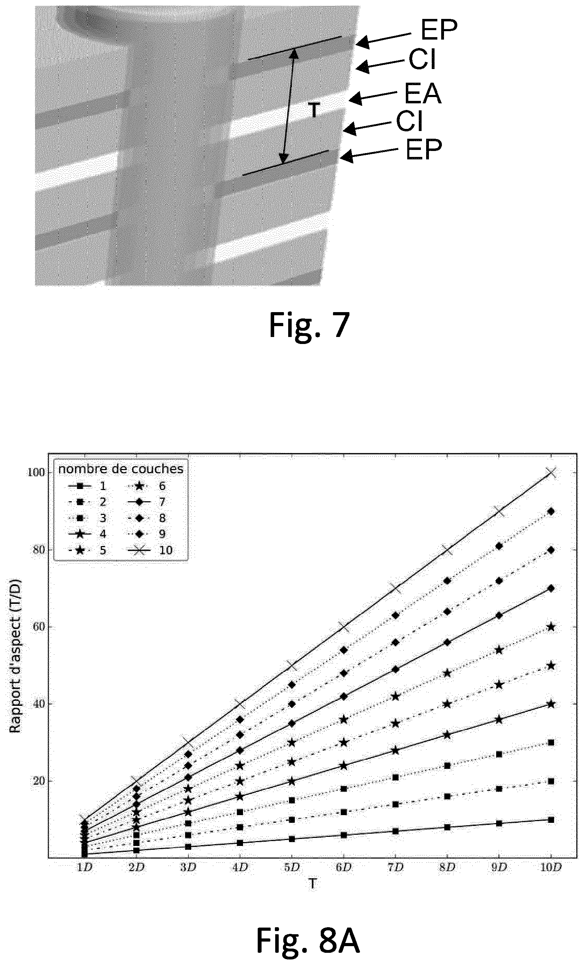

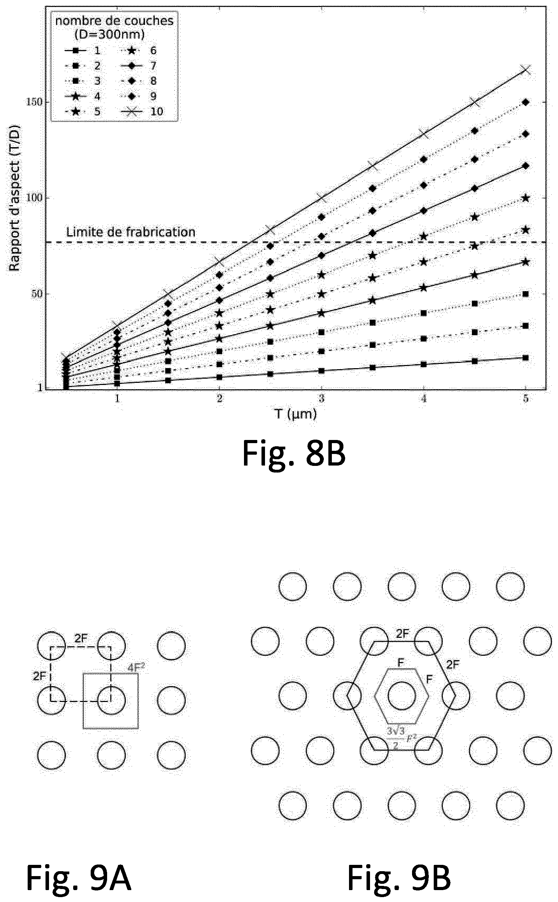

Lorsque les paramètres F et D sont fixés, il est possible de faire varier l'épaisseur T de la couche d'électrolyte CI entre l'électrode plane EP et l'électrode active EA où l'épaisseur est définie comme la distance séparant deux électrodes planes EP, comme cela est illustré sur la figure 7. De manière générale, une épaisseur T plus élevée permet de stocker plus d'énergie (le matériau composant la couche d'électrolyte CI possédant une densité de charge volumique maximale dictée par le nombre de sites d'insertion d'ions disponibles par unité de volume de matériau), mais diminue le nombre de points mémoires PM par cellule mémoire CM. Afin de mesurer l'influence de ce paramètre, la figure 8A présente la valeur de l'aspect de forme T/D (épaisseur T sur diamètre D - en ordonnée) en fonction de l'épaisseur de la couche T (en abscisse) et du nombre de couches d'électrolyte CI (chaque courbe correspond à un nombre de couches d'électrolyte CI donné). Plus l'épaisseur T est élevée et plus l'aspect de forme est important pour un nombre de couches donné. Cependant, pour une épaisseur T donnée, il n'est généralement pas possible de descendre en dessous d'un diamètre D minimum correspondant aux limites de fabrications en termes d'aspect de forme. Ceci est illustré sur la figure 8B dans lequel l'aspect de forme limite est sensiblement égal à 77. En considérant un diamètre D égal à 300nm, cela signifie que pour une épaisseur T de 2µm, il est possible d'envisager une structure à dix couches d'électrolyte CI alors que pour une épaisseur T de 2.5µm, le nombre de couches d'électrolyte CI sera limité à neuf couches du fait des contraintes de fabrication. La valeur limite de l'aspect de forme dépend du procédé de fabrication employé pour obtenir le composant selon un premier aspect de l'invention, et en particulier l'électrode verticale EV. Ainsi, pour un diamètre D, une distance F et un objectif Qtot donnés, la densité de charge correspondante peut être déterminée. Cette dernière permet de calculer l'épaisseur T nécessaire, cette dernière permettant à son tour de déterminer, compte tenu de la limite au niveau du facteur de forme, le nombre de couches d'électrolyte maximum (et donc le nombre de points mémoire PM et de zones de stockage de l'énergie ZSE par cellule mémoire CM).

S'il n'est pas possible d'atteindre la densité de charge cible, il est également envisageable de recharger (autrement dit de rafraichir la charge) la zone de stockage de l'énergie ZSE plus régulièrement. Par exemple, si la densité de charge nécessaire à 2x10⁶ opérations ne peut pas être atteinte, il est possible de mettre en place une étape de chargement de la zone de stockage de l'énergie ZSE toutes les 2x10⁴ opérations par exemple. Ce rafraichissement peut venir en complément de celui permettant de tenir compte de la perturbation électrique générée par les opérations effectuées sur les points mémoires PM (qui sera décrit dans la suite) ou en remplacement de ce dernier.

En plus des différents paramètres évoqués précédemment, il est également possible de faire varier la disposition des piliers verticaux EV les uns par rapport aux autres. La figure 9A illustre une première disposition dans laquelle la projection de la pluralité de piliers verticaux PI sur un plan parallèle aux plans formés par les électrodes planes EP forme un réseau dont la maille élémentaire est une maille carrée. La figure 9B illustre quant à elle une deuxième disposition dans laquelle la projection de la pluralité de piliers verticaux PI sur un plan parallèle aux plans formés par les électrodes plane EP forme un réseau dont la maille élémentaire est une maille losange. La structure de la figure 9B propose une densité de piliers verticaux PI (et donc de points mémoires PM) plus importante que la structure de la figure 9A et favorise la fonction de stockage de l'information au détriment de la fonction stockage de l'énergie comparativement à la structure de la figure 9A. On pourra donc choisir l'une ou l'autre des dispositions selon que l'on souhaite favoriser le stockage de l'information ou le stockage de l'énergie. D'autres mailles élémentaires peuvent bien entendu être envisagées.

Comme cela vient d'être présenté, il est possible de modifier les paramètres structurels d'un composant selon un premier aspect de l'invention et de tenir compte de la fonctionnalité principale à laquelle il est destiné dans le choix de ces paramètres. Ces variations ne se limitent cependant pas aux seules propriétés géométriques (dispositions et dimensions), mais également aux choix dans les matériaux utilisés. Dans un mode de réalisation, l'électrode plane EP (ou la deuxième couche EP2 de l'électrode plane EP quand cette dernière est multicouches) est réalisée à partir d'un métal inerte tel que le nitrure de titane TiN, le platine Pt, le tungstène W ou un alliage comprenant tout ou partie de ces éléments. Dans un mode de réalisation, l'électrode active EA est réalisée à partir d'un métal source d'ions tel que le cuivre Cu, l'argent Ag, le lithium Li, l'or Au ou un alliage comprenant tout ou partie de ces éléments (il en est de même de la première couche EP1 et de la troisième couche EP3 de l'électrode plane EP lorsque cette dernière est multicouches). Dans un mode de réalisation, la couche d'électrolyte CI est réalisée à partir d'un isolant à travers lequel les ions peuvent diffuser tels que l'oxyde de silicium SiO₂, l'oxyde de hafnium HfO₂, de l'oxyde de tantale Ta₂O₅. Dans un mode de réalisation, la couche de stockage de l'information SCI comprend une couche réalisée à partir d'un métal source d'ions tel que le cuivre Cu, l'argent Ag ou un alliage comprenant tout ou partie de ces éléments, ou bien une source de lacunes telle que le titane Ti, le hafnium Hf ou un alliage comprenant tout ou partie de ces éléments.

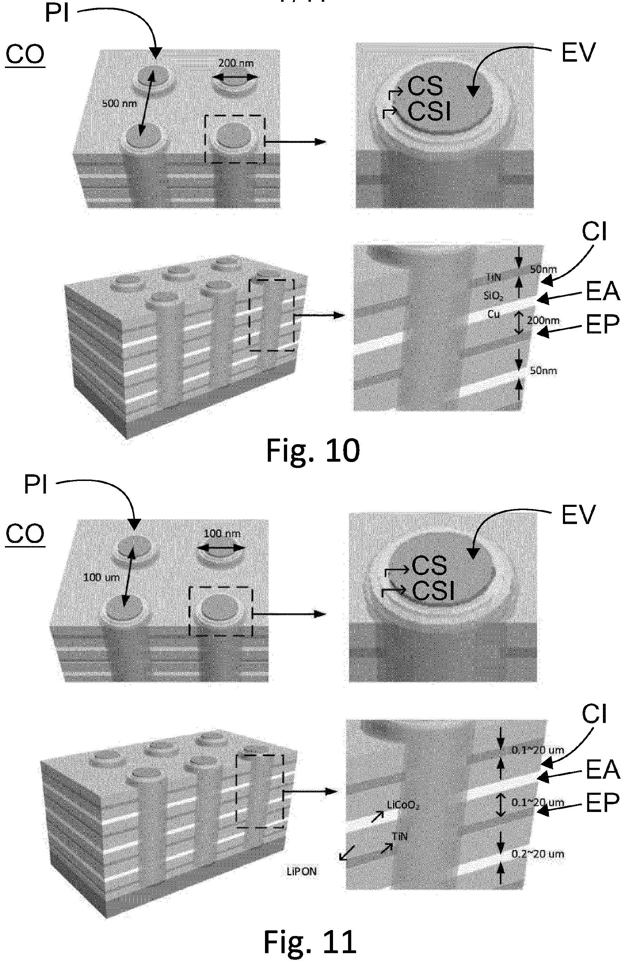

Un premier exemple de réalisation d'un composant selon un premier aspect de l'invention est illustré à la figure 10. Ce premier exemple est favorable aux performances mémoire. En effet il intègre une épaisseur d'électrolyte (SiO2) relativement faible (200nm), permettant un facteur de forme modéré de l'empilement. Il est donc possible d'intégrer plus de points mémoires PM, donc une plus grande densité de la mémoire. Dans ce composant, la distance 2F séparant deux piliers verticaux PI est égale à 500 nm (F=250 nm) et le diamètre D du pilier vertical PI est égal à 200 nm. De plus, la projection des piliers verticaux PI sur un plan parallèle aux plans formés par les électrodes planes EP forme un réseau de maille élémentaire carrée. La couche de stockage de l'information CSI comporte une couche de titane Ti d'une épaisseur égale à 5 nm et une couche d'oxyde d'hafnium HfO₂ d'une épaisseur de 10 nm. La couche de sélection SC a une épaisseur inférieure à 50nm et est située entre la couche d'oxyde d'hafnium HfO₂ de la couche de stockage de l'information CSI et l'électrode verticale EV, la couche de sélection SC couvrant une surface de l'électrode verticale EV. L'électrode verticale EV est quant à elle constituée de nitrure de titane TiN. En outre, les électrodes planes EP sont constituées de nitrure de titane TiN et ont une épaisseur de 50 nm. Les électrodes actives EA sont quant à elles composées de cuivre Cu et ont également une épaisseur de 50 nm. Enfin, les couches d'électrolyte CI sont composées d'oxyde de silicium SiO₂ et ont chacune une épaisseur de 200 nm.

Un deuxième exemple de réalisation d'un composant selon un premier aspect de l'invention est illustré à la figure 11. Ce deuxième exemple est favorable au stockage de l'énergie, car elle intègre un empilement de zones de stockage de l'information permettant de stocker plus d'énergie. En revanche, l'épaisseur de l'électrolyte et de l'électrode active étant plus important que dans le premier cas (jusqu'à 20µm dans le cas présent), le facteur de forme est très élevé, ce qui se fait au détriment du nombre de points mémoires PM que l'on peut intégrer, donc une densité mémoire plus faible. Dans ce composant, la distance 2F est égale à 100 µm (F=50µm) et le diamètre D est égal à 100 nm. De plus, la projection des piliers verticaux PI sur un plan parallèle aux plans formés par les électrodes planes EP forme un réseau de maille élémentaire carrée. La couche de stockage de l'information CSI comporte une couche de titane Ti d'une épaisseur égale à 5 nm, et une couche d'oxyde d'hafnium HfO₂ d'une épaisseur de 10 nm. La couche de sélection SC a une épaisseur inférieure à 20 nm et est située entre la couche d'oxyde d'hafnium HfO₂ de la couche de stockage de l'information CSI et l'électrode verticale EV, la couche de sélection CS couvrant une surface de l'électrode verticale EV. L'électrode verticale EV est constituée de nitrure de titane TiN. En outre, les électrodes planes EP sont constituées de nitrure de titane TiN et ont une épaisseur comprise entre 0.2 et 20 µm. Les électrodes actives EA sont quant à elles composées de LiCoO₂ ont une épaisseur comprise entre 0.1 et 20 µm. Enfin, les couches d'électrolyte CI sont composées de LiPON dielectric et ont chacune une épaisseur comprise entre 0.1 et 20 µm. Il est à noter que dans ce cas, le stockage de l'énergie est assuré par la couche LiCoO2. Aussi, seule l'augmentation de cette couche permet d'optimiser la capacité de stockage.

Comme l'indique les ratios D/L diamètre des piliers D sur distance inter-piliers F de chaque composant, le premier composant privilégie le stockage de l'information par rapport au deuxième composant. Cette tendance est encore accentuée par le choix d'une couche d'électrolyte CI plus épaisse dans le cas du deuxième composant favorisant le stockage de l'énergie au détriment du stockage de l'information. Ces deux exemples permettent d'illustrer comment il est possible de faire varier les différents paramètres d'un composant selon un premier aspect de l'invention en fonction de la fonctionnalité que l'on cherche à privilégier.

Bien entendu, d'autres facteurs que les dimensions ou les matériaux utilisés peuvent être choisis de sorte à optimiser les propriétés d'un composant selon l'invention. Il par exemple important de choisir la technique de gravure permettant d'obtenir un aspect de forme aussi élevé que possible. L'utilisation d'un procédé de gravure sélectif permet par exemple d'obtenir une couche de stockage de l'information CSI plus épaisse ce qui réduit les courant de fuite entre la ou les électrodes actives EA et l'électrode verticale EV, ladite couche CSI se comportant comme un isolant entre ces deux types d'électrodes EA, EV.

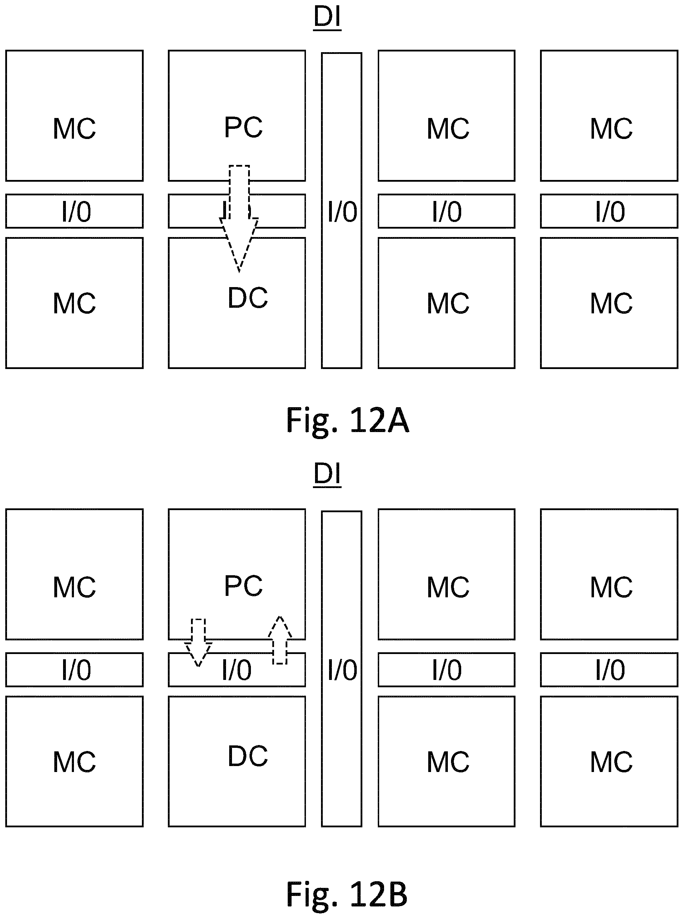

Dans un deuxième aspect de l'invention illustré aux figures 12A et 12B, l'invention concerne dispositif semi-conducteur comprenant au moins un premier composant PC, selon un premier aspect de l'invention. Le dispositif peut également comprendre des composants supplémentaires MC, DC. Dans un mode de réalisation, les matériaux et les dimensions du premier composant PC sont choisies de sorte à favoriser le stockage de l'énergie. Dans un mode de réalisation illustré à la figure 12A, le premier composant PC est configuré pour fournir de l'énergie à un deuxième composant DC. Dans un mode de réalisation, le deuxième composant DC est un composant selon un premier aspect de l'invention, par exemple un composant selon un premier aspect de l'invention dont les matériaux et les dimensions sont choisies de sorte à favoriser le stockage de l'information. Dans un mode de réalisation illustré à la figure 12B, le dispositif selon un deuxième aspect de l'invention comporte un système d'entrée/sortie I/O, ledit système d'entrée/sortie I/O étant configuré pour que le premier composant PC utilise l'énergie stockée dans les nano-piles NP dudit premier composant PC pour alimenter les cellules mémoire CM dudit premier composant PC.

Autrement dit, un composant CO selon un premier aspect de l'invention, une fois intégré à un dispositif DI, peut s'autoalimenter en énergie et/ou alimenter un deuxième composant DC, le deuxième composant DC pouvant être un composant selon un premier aspect de l'invention ou tout autre composant nécessitant une alimentation en énergie. Ainsi, un composant CO selon un premier aspect de l'invention peut être utilisé soit en tant que composant destiné au stockage de l'information, soit en tant que composant destiné au stockage de l'énergie ou bien encore un composant destiné à la fois au stockage de l'information et au stockage de l'énergie. Il est donc possible d'utiliser le même composant au sein d'un dispositif pour stocker des informations et/ou de l'énergie de manière parfaitement intégrée.

Pour cela, un troisième aspect de l'invention concerne un procédé d'utilisation d'un dispositif DI semi-conducteur comportant un premier et un deuxième composant CO semi-conducteur selon un premier aspect de l'invention. Le procédé selon un troisième aspect de l'invention comporte une étape dans laquelle le premier composant PC semi-conducteur est utilisé pour le stockage d'information ; et une étape dans laquelle le deuxième composant DC semi-conducteur est utilisé pour le stockage de l'énergie.

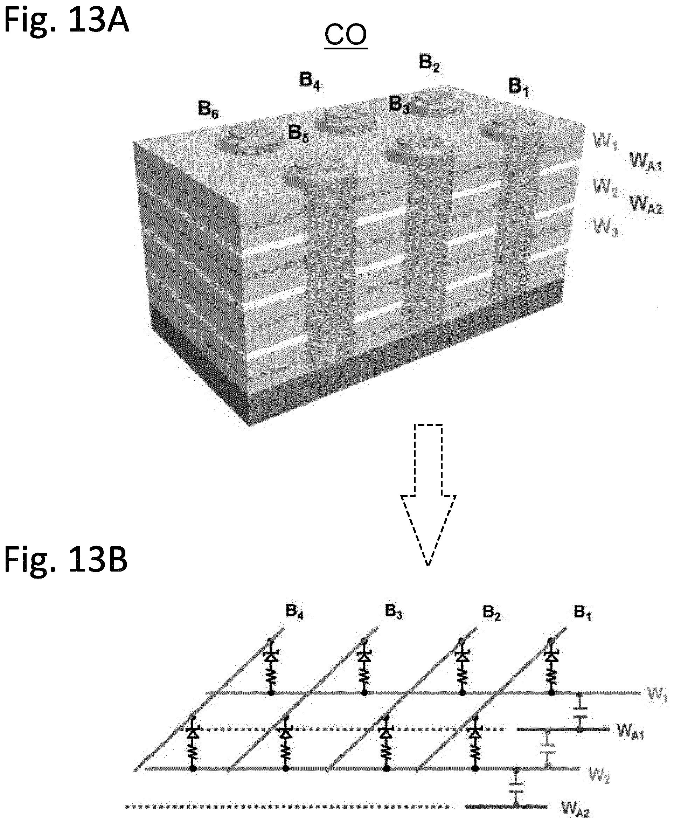

Les figures 13A et 13B illustrent un schéma électrique équivalent d'un composant selon un premier aspect de l'invention. Les électrodes verticales EV sont représentées par les références Bi avec i un entier compris entre 1 et 4. Les électrodes planes EP sont représentées par les références Wi avec i un entier égal à 1 ou 2. Enfin, les électrodes actives EA sont représentées par les références W_{Ai} avec i un entier égal à 1 ou 2. Chaque électrode plane EP est reliée électriquement à chaque électrode verticale EV par une diode Zener (représentant la couche de sélection SC) en série avec une résistance (représentant la couche de stockage de l'information CSI). De plus, chaque électrode active EA est reliée à chaque électrode plane EP adjacente par une capacité (représentant la zone de stockage de l'énergie ZSE). En revanche, les électrodes actives EA ne sont pas reliées électriquement aux électrodes verticales EV du fait de la couche de stockage de l'information CSI qui se comporte comme un isolant entre les électrodes actives EA et les électrodes verticales EV, aucun filament n'étant formé au niveau de cette dernière.

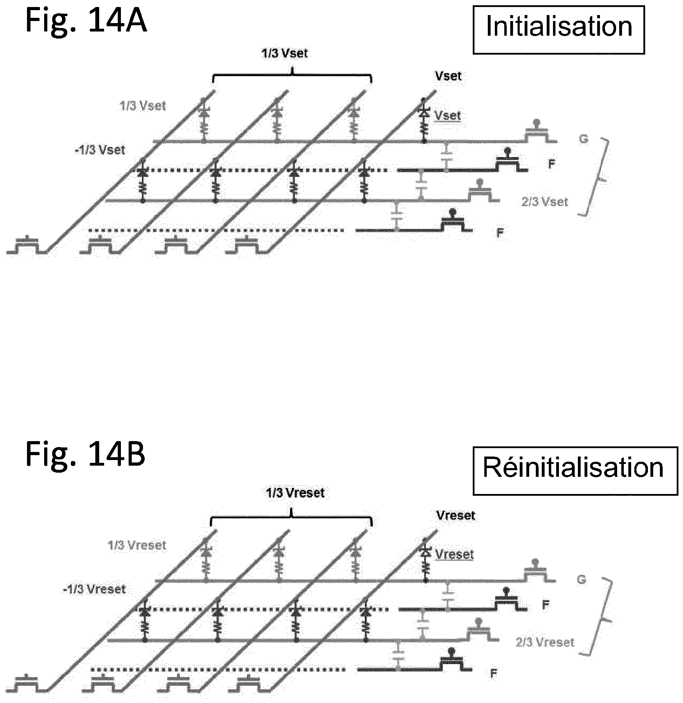

Afin de pouvoir mettre en œuvre une étape dans laquelle un composant semi-conducteur selon un premier aspect de l'invention est utilisé pour le stockage de l'information et/ou pour le stockage de l'énergie, il est nécessaire d'appliquer un jeu de tensions bien définies de sorte à initialiser/réinitialiser les points mémoires PM ou charger/décharger les zones de stockage de l'énergie ZSE. Le tableau 2 décrit les différentes tensions correspondant aux différentes opérations avec Vₛₑₜ la tension qu'il est nécessaire d'appliquer sur un point mémoire PM pour initialiser (écrire une information) ce dernier, Vᵣₑₛₑₜ la tension qu'il est nécessaire d'appliquer sur un point mémoire PM pour réinitialiser (effacer une information) ce dernier, V_{charge} la tension qu'il est nécessaire d'appliquer sur une zone de stockage de l'énergie ZSE pour la charger et V_{discharge} est la tension qu'il est nécessaire d'appliquer sur une zone de stockage de l'énergie ZSE pour la décharger. Dans le tableau 2 et les figures 14A à 15B, la lettre G signifie que le potentiel est maintenu à la masse et la lettre F signifie que le potentiel est flottant. Dans un mode de réalisation, la tension d'initialisation Vₛₑₜ est égale à 1V, la tension de réinitialisation Vᵣₑₛₑₜ est égale à -1V, la tension de charge V_{charge} est égale à -1.5V et la tension de décharge V_{discharge} est égale à 0V.

**Tableau 2**

| **1/3 Vₛₑₜ mode** | | **B₁** | **Bₙ** | **W₁** | **Wₙ** | **W_{A1}** | **W_{An}** |
|---|---|---|---|---|---|---|---|
| **Initialisation** | **Temps court** | Vₛₑₜ | 1/3Vₛₑₜ | G | 2/3Vₛₑₜ | F | F |
| **Réinitialisation** | | Vᵣₑₛₑₜ | 1/3Vᵣₑₛₑₜ | G | 2/3Vₛₑₜ | F | F |
| **Charge** | **Temps long** | F | F | G | F | V_{charge} | F |
| **Décharge** | | F | F | V_{discharge} | F | V_{discharge} | F |

Les figures 14A et 14B illustrent les opérations d'initialisation et de réinitialisation des points mémoires PM. Comme illustré à la figure 14A, afin d'initialiser un point mémoire PM, le potentiel de l'électrode plane EP correspondante audit point mémoire PM est maintenu à la masse alors que l'électrode verticale EV correspondant audit point mémoire PM est polarisé à une tension Vₛₑₜ. Durant cette opération d'initialisation, les autres électrodes verticales EV sont polarisées à une tension 1/3Vₛₑₜ, la polarisation des électrodes actives EA est flottante, les autres électrodes planes EP étant polarisées à une tension de 2/3Vₛₑₜ. Cela signifie donc que durant cette opération, le point mémoire PM cible se voit appliquer une tension Vₛₑₜ tandis que les autres points mémoires PM se voient appliqué une tension égale 1/3Vₛₑₜ pour les points mémoires PM ayant en commun avec le point mémoire PM cible l'électrode plane EP ou l'électrode verticale EV et -1/3Vₛₑₜ pour les autres points mémoires PM. Comme illustré à la figure 14B, afin de réinitialiser un point mémoire PM, la polarisation de l'électrode plane EP correspondante audit point mémoire PM est maintenue à la masse alors que l'électrode verticale EV correspondant audit point mémoire PM est polarisée à une tension Vᵣₑₛₑₜ. Durant cette opération de réinitialisation, les autres électrodes verticales EV sont polarisées à une tension 1/3Vᵣₑₛₑₜ, la polarisation des électrodes actives EA est flottante, et les autres électrodes planes EP sont polarisées à une tension de 2/3Vᵣₑₛₑₜ. Cela signifie donc que durant cette opération, le point mémoire PM cible se voit appliqué une tension Vᵣₑₛₑₜ tandis que les autres points mémoires PM se voient appliqué une tension égale 1/3Vᵣₑₛₑₜ pour les point mémoire PM ayant en commun avec le point mémoire PM cible l'électrode plane EP ou l'électrode verticale EV et -1/3 Vᵣₑₛₑₜ pour les autres points mémoires PM.

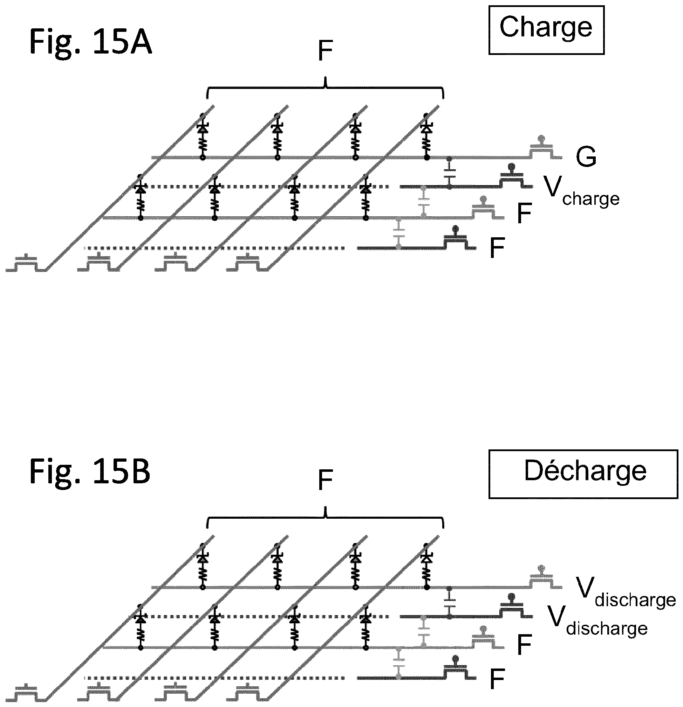

Les figures 15A et 15B illustrent les opérations de charge et de décharge des zones de stockage de l'énergie ZSE. Comme illustré à la figure 15A, afin de charger une zone de stockage de l'énergie ZSE, la tension V_{charge} est appliquée sur l'électrode active EA correspondant à la zone de stockage de l'énergie ZSE que l'on souhaite charger alors que le potentiel de l'électrode plane EP correspondant à la zone de stockage de l'énergie ZSE est maintenue à la masse. Durant cette opération, les autres électrodes sont quant à elles à un potentiel flottant (autrement dit déconnectées de toute référence de potentiel). Comme illustré à la figure 15B, afin de décharger la zone de stockage de l'énergie ZSE, une tension de décharge V_{discharge} est appliquée sur l'électrode active EA et sur l'électrode plane EP correspondant à la zone de stockage de l'énergie ZSE que l'on souhaite décharger.

De la même manière que pour la charge, les autres électrodes sont quant à elles à un potentiel flottant.

Il est important de noter que les tensions appliquées pour les opérations d'initialisation et de réinitialisation d'un point mémoire PM sont appliquées durant un temps très court comparativement au temps nécessaire pour les opérations de charge et de décharge des zones de stockage de l'énergie ZSE. La cinétique des zones de stockage de l'énergie ZSE n'est donc affectée qu'à la marge durant lesdites opérations d'initialisation et/ou de réinitialisation. Cependant, afin de s'assurer de la bonne charge desdites zones de stockage de l'énergie ZSE, il est également possible de mettre en œuvre un cycle de charge de la ou des deux zones de stockage de l'énergie correspondant à un point mémoire PM tous les Nᵣ cycles d'initialisation/réinitialisation dudit point mémoire PM où Nᵣ est le ratio entre le temps caractéristique des opérations d'initialisation et de réinitialisation d'un point mémoire PM noté tₘ et le temps caractéristique de décharge d'une zone de stockage de l'énergie ZSE noté t_{décharge}, autrement dit Nᵣ=t_{décharge}/tₘ. Autrement dit, lorsqu'un point mémoire PM a subi Nᵣ opérations d'initialisation ou de réinitialisation, la zone de stockage de l'énergie ZSE ou les deux zones de stockage de l'énergie ZSE correspondant audit point mémoire PM subissent un rafraichissement.

Dans un mode de réalisation, l'énergie nécessaire à l'étape d'utilisation d'au moins un composant pour le stockage de l'information est fournie par l'énergie stockée lors de l'étape dans laquelle au moins un composant semi-conducteur est utilisé pour le stockage d'énergie. Ainsi, l'énergie est utilisée et stockée au sein d'un même dispositif ce qui améliore considérablement l'intégration de l'alimentation en énergie des composants dudit dispositif.

## Revendications

1. Composant (CO) semi-conducteur comprenant :
- une première électrode (EP), dite électrode plane (EP), définissant un plan ;
- une deuxième électrode (EA), dite électrode active (EA), séparée de la première électrode (EP) par une couche d'électrolyte (CI) ;
- un pilier (PI), dit pilier vertical (PI), s'étendant essentiellement selon un axe perpendiculaire au plan défini par l'électrode plane (EP), ledit pilier (PI) comprenant une troisième électrode (EV), dite électrode verticale (EV) et une couche de stockage de l'information (CSI), la couche de stockage de l'information (CSI) recouvrant une surface de l'électrode verticale (EV) ; l'électrode plane (EP) et le pilier vertical (PI) étant agencés de sorte à former un point mémoire (PM) ;
ledit composant (CO) étant **caractérisé en ce que** les matériaux de l'électrode active (EA) et de la couche d'électrolyte (CI) sont choisis de sorte à former une zone de stockage de l'énergie (ZSE) avec l'électrode plane (EP).

2. Composant (CO) selon la revendication précédente **caractérisé en ce que** l'électrode plane (EP) comporte un première couche (EP1) et une deuxième couche (EP2), ladite première couche (EP1) étant en regard de l'électrode active (EA) et constitué d'un matériau source d'ions, la deuxième couche (EP2) et le pilier vertical (PI) formant le point mémoire (PM) et la première couche (EP1), la couche d'électrolyte (CI) et l'électrode active (EA) formant la zone de stockage de l'énergie (ZSE).

3. Composant (CO) selon l'un des deux revendications précédentes **caractérisé en ce que** le pilier vertical (PI) comprend en outre une couche de sélection (CS), ladite couche de sélection (CS) étant située entre l'électrode verticale (EV) et la couche de stockage de l'information (CSI) ou sur la couche de stockage de l'information (CSI).

4. Composant (CO) selon l'une des revendications précédentes **caractérisé en ce qu'**il comporte une pluralité d'électrodes planes (EP), une pluralité de couches d'électrolyte (CI) et une pluralité d'électrodes actives (EA), chaque électrode plane (EP) de la pluralité d'électrodes planes (EP) étant agencée de sorte à former un point mémoire (PM) avec le pilier vertical (EV) ; et chaque électrode active (EA) de la pluralité d'électrodes actives (EA) étant séparée d'une électrode plane (EP) de la pluralité d'électrodes planes (EP) par une couche d'électrolyte (CI) de la pluralité de couches d'électrolyte (CI) de sorte à former une zone de stockage de l'énergie (ZSE).

5. Composant (CO) selon la revendication précédente **caractérisé en ce que** chaque électrode plane (EP) comporte une troisième couche (EP3), ladite troisième couche (EP3) étant en regard d'une électrode active (EA) de la pluralité d'électrodes actives (EA), séparée de ladite électrode active (EA) par une couche d'électrolyte (CI) de la pluralité de couche d'électrolyte (CI) et constituée d'un matériau source d'ions, ladite troisième couche (EP3), ladite couche d'électrolyte (CI) et ladite électrode active (EA) formant une zone de stockage de l'énergie (ZSE).

6. Composant (CO) selon la revendication précédente **caractérisé en ce que** la première couche (EP1) et/ou la troisième couche (EP3) de chaque électrode plane (EP) de la pluralité d'électrode plane (EP) ne sont pas en contact avec le pilier vertical (PI).

7. Composant (CO) selon la revendication 4 **caractérisé en ce que** la première couche (EP1) et/ou la troisième couche (EP3) de chaque électrode plane (EP) de la pluralité d'électrode plane (EP) sont séparées du pilier vertical (PI) par un matériau isolant.

8. Composant (CO) selon l'une des revendications précédentes **caractérisé en ce que** le matériau de l'électrode verticale (EV) et le matériau de la couche de stockage de l'information (CSI) sont choisi de sorte à former, avec l'électrode plane (EP) ou avec chaque électrode plane (EP) de la pluralité d'électrodes planes (EP), un point mémoire (PM) à changement de phase ou un point mémoire (PM) résistif.

9. Composant (CO) selon l'une des revendications précédentes **caractérisé en ce qu'**il comprend une pluralité de piliers verticaux (PI) chaque pilier vertical (PI) étant agencé de sorte à former un point mémoire (PM) avec l'électrode plane (EP) ou avec chaque électrode plane (EP) de la pluralité d'électrodes planes (EP).

10. Composant (CO) selon la revendication précédente **caractérisé en ce que** la projection des piliers verticaux (PI) de la pluralité de piliers verticaux (PI) sur un plan parallèle au plan formé par l'électrode plane (EP) ou aux plans formés par les électrodes planes (EP) de la pluralité d'électrodes planes (EP) forme un réseau dont la maille élémentaire est une maille carrée ou une maille losange.

11. Dispositif (DI) semi-conducteur **caractérisé en ce qu'**il comprend un composant (CO) selon l'une des revendications précédentes des moyens pour que ledit composant (CO) soit utilisé pour le stockage d'information et/ou pour le stockage d'énergie.

12. Dispositif (DI) selon la revendication précédente **caractérisé en ce qu'**il comporte un deuxième composant (CO) selon l'une des revendications 1 à 6 et des moyens pour que le deuxième composant (CO) soit utilisé pour le stockage d'information et/ou pour le stockage d'énergie.

13. Procédé d'utilisation d'un dispositif (DI) selon la revendication précédente **caractérisé en ce qu'**il comporte :
- une étape dans laquelle au moins un parmi le premier ou le deuxième composant (CO) semi-conducteur est utilisé pour le stockage d'information ;
- une étape dans laquelle au moins un parmi le premier ou le deuxième composant (CO) semi-conducteur est utilisé pour le stockage d'énergie.

14. Procédé selon la revendication précédente **caractérisé en ce que** l'énergie nécessaire à l'étape d'utilisation d'au moins un composant (CO) pour le stockage de l'information est fournie par l'énergie stockée lors de l'étape dans laquelle au moins un composant (CO) est utilisé pour le stockage d'énergie.

## Patentansprüche

1. Halbleiterbauteil (CO), umfassend:
- eine erste Elektrode (EP), bezeichnet als ebene Elektrode (EP), die eine Ebene definiert;
- eine zweite Elektrode (EA), bezeichnet als aktive Elektrode (EA), die von der ersten Elektrode (EP) durch eine Elektrolytschicht (CI9 getrennt ist;
- einen Pfeiler (PI), bezeichnet als vertikalen Pfeiler (PI), der sich im Wesentlichen gemäß einer zur von der ebenen Elektrode (EP) definierten lotrechten Achse erstreckt, wobei der genannte Pfeiler (PI) eine dritte Elektrode (EV), bezeichnet als vertikale Elektrode (EV), und eine Speicherschicht der Information (CSI) umfasst, wobei die Speicherschicht der Information (CSI) eine Oberfläche der vertikalen Elektrode (EV) abdeckt; wobei die ebene Elektrode (EP) und der vertikale Pfeiler (PI) derart angeordnet sind, dass sie einen Speicherpunkt (PM) formen;
wobei das genannte Bauteil (CO) **dadurch gekennzeichnet ist, dass** die Materialien der aktiven Elektrode (EA) und der Elektrolytschicht (CI) derart ausgewählt sind, dass sie einen Speicherbereich der Energie (ZSE) mit der ebenen Elektrode (EP) formen.

2. Bauteil (CO) gemäß dem voranstehenden Anspruch, **dadurch gekennzeichnet, dass** die ebene Elektrode (EP) eine erste Schicht (EP1) und eine zweite Schicht (EP2) umfasst, wobei die erste Schicht (EP1) gegenüber der aktiven Elektrode ist und aus einem lonen-Quellmaterial gebildet ist, wobei die zweite Schicht (EP2) und der vertikale Pfeiler (PI) den Speicherpunkt (PM) bilden und die erste Schicht (EP1), die Elektrolytschicht (CI) und die aktive Elektrode (EA) den Speicherbereich der Energie (ZSE) bilden.

3. Bauteil (CO) gemäß einem der zwei voranstehenden Ansprüche, **dadurch gekennzeichnet, dass** der vertikale Pfeiler (PI) darüber hinaus eine Auswahlschicht (CS) umfasst, wobei die genannte Auswahlschicht (CS) zwischen der vertikalen Elektrode (EV) und der Speicherschicht der Information (CSI) oder auf der Speicherschicht der Information (CSI) angeordnet ist.

4. Bauteil (CO) gemäß einem der voranstehenden Ansprüche, **dadurch gekennzeichnet, dass** es eine Vielzahl von ebenen Elektroden (EP), eine Vielzahl von Elektrolytschichten (CI) und eine Vielzahl von aktiven Elektroden (EA) umfasst, wobei jede ebene Elektrode (EP) der Vielzahl von ebenen Elektroden (EP) derart angeordnet ist, dass sie mit dem vertikalen Pfeiler (EV) einen Speicherpunkt (PM) bildet; und wobei jede aktive Elektrode (EA) der Vielzahl von aktiven Elektroden (EA) von einer ebenen Elektrode (EP) der Vielzahl von ebenen Elektroden (EP) durch eine Elektrolytschicht (CI) der Vielzahl von Elektrolytschichten (CI) derart getrennt ist, dass ein Speicherbereich der Energie (ZSE) gebildet ist.

5. Bauteil (CO) gemäß dem voranstehenden Anspruch, **dadurch gekennzeichnet, dass** jede ebene Elektrode (EP) eine dritte Schicht (EP3) umfasst, wobei die dritte Schicht (EP3) gegenüber einer aktiven Elektrode (EA) von der Vielzahl von aktiven Elektroden (EA) gegenüber ist, die von der genannten aktiven Elektrode (EA) durch eine Elektrolytschicht (CI) von der Vielzahl von Elektrolytschichten (CI) getrennt und aus einem lonen-Quellmaterial gebildet ist, wobei die genannte dritte Schicht (EP3), die genannte Elektrolytschicht (CI) und die genannte aktive Elektrode (EA) einen Speicherbereich der Energie (ZSE) bilden.

6. Bauteil (CO) gemäß dem voranstehenden Anspruch, **dadurch gekennzeichnet, dass** die erste Schicht (EP1) und / oder die dritte Schicht (EP3) jeder ebenen Elektrode (EP) der Vielzahl von ebenen Elektroden (EP) nicht mit dem vertikalen Pfeiler in Kontakt ist / sind.

7. Bauteil (CO) gemäß Anspruch 4, **dadurch gekennzeichnet, dass** die erste Schicht (EP1) und / oder die dritte Schicht (EP3) jeder ebenen Elektrode (EP) der Vielzahl von ebenen Elektroden (EP) von dem vertikalen Pfeiler (PI) durch ein isolierendes Material getrennt ist / sind.

8. Bauteil (CO) gemäß einem der voranstehenden Ansprüche, **dadurch gekennzeichnet, dass** das Material der vertikalen Elektrode (EV) und das Material der Speicherschicht der Information (CSI) derart ausgewählt sind, dass sie mit der ebenen Elektrode (EP) oder mit jeder ebenen Elektrode (EP) der Vielzahl von ebenen Elektroden (EP) einen Speicherpunkt (PM) mit Phasenumwandlung oder einen ohmschen Speicherpunkt (PM) bilden.

9. Bauteil (CO) gemäß einem der voranstehenden Ansprüche, **dadurch gekennzeichnet, dass** es eine Vielzahl von vertikalen Pfeilern (PI) umfasst, wobei jeder vertikale Pfeiler (PI) derart angeordnet ist, dass er mit der ebenen Elektrode (EP) oder mit jeder ebenen Elektrode (EP) der Vielzahl von ebenen Elektroden (EP) einen Speicherpunkt (PM) formt.

10. Bauteil (CO) gemäß dem voranstehenden Anspruch, **dadurch gekennzeichnet, dass** die Projektion der vertikalen Pfeiler (PI) der Vielzahl von vertikalen Pfeilern (PI) auf einer Ebene, die zu der Ebene, die von der ebenen Elektrode (EP) gebildet ist, oder zu den Ebenen parallel ist, die von den ebenen Elektroden (EP) der Vielzahl von ebenen Elektroden (EP) geformt sind, ein Netz formt, dessen elementare Masche eine quadratische Masche oder eine rautenförmige Masche ist.

11. Halbleitervorrichtung (DI), **dadurch gekennzeichnet, dass** sie ein Bauteil (CO) gemäß einem der voranstehenden Ansprüche der Mittel umfasst, damit das genannte Bauteil (CO) für die Speicherung von Informationen und / oder für die Speicherung von Energie verwendet ist.

12. Vorrichtung (DI) gemäß dem voranstehenden Anspruch, **dadurch gekennzeichnet, dass** sie ein zweites Bauteil (CO) gemäß einem der Ansprüche 1 bis 6 und Mittel umfasst, damit das zweite Bauteil (CO) für die Speicherung von Informationen und / oder für die Speicherung von Energie verwendet ist.

13. Verfahren zur Verwendung einer Vorrichtung (DI) gemäß dem voranstehenden Anspruch, **dadurch gekennzeichnet, dass** es umfasst:
- einen Schritt, bei dem wenigsten eines von dem ersten oder dem zweiten Halbleiterbauteil (CO) für die Speicherung von Informationen verwendet sind;
- einen Schritt, bei dem wenigstens eines von dem ersten oder dem zweiten Halbleiterbauteil (CO) für die Speicherung von Energie verwendet sind.

14. Verfahren gemäß dem voranstehenden Anspruch, **dadurch gekennzeichnet, dass** die für den Verwendungsschritt notwendige Energie wenigstens eines Bauteils (CO) für die Speicherung der Information von der Energie geliefert wird, die bei dem Schritt gespeichert wird, bei dem wenigstens ein Bauteil (CO) für die Speicherung von Energie verwendet wird.

## Claims

1. Semiconductor component (CO) including:
- a first electrode (EP), designated flat electrode (EP), defining a plane;
- a second electrode (EA), designated active electrode (EA), separated from the first electrode (EP) by an electrolyte layer (CI);
- a pillar (PI), designated vertical pillar (PI), extending essentially along an axis perpendicular to the plane defined by the flat electrode (EP), said pillar (PI) including a third electrode (EV), designated vertical electrode (EV) and an information storage layer (CSI), the information storage layer (CSI) covering a surface of the vertical electrode (EV); the flat electrode (EP) and the vertical pillar (PI) being laid out so as to form a memory point (PM);
said component (CO) being **characterised in that** the materials of the active electrode (EA) and the electrolyte layer (CI) are chosen so as to form an energy storage zone (ZSE) with the flat electrode (EP).

2. Component (CO) according to the preceding claim **characterised in that** the flat electrode (EP) comprises a first layer (EP1) and a second layer (EP2), said first layer (EP1) facing the active electrode (EA) and being constituted of an ion source material, the second layer (EP2) and the vertical pillar (PI) forming the memory point (PM) and the first layer (EP1), the electrolyte layer (CI) and the active electrode (EA) forming the energy storage zone (ZSE).

3. Component (CO) according to one of the two preceding claims **characterised in that** the vertical pillar (PI) further includes a selection layer (CS), said selection layer (CS) being situated between the vertical electrode (EV) and the information storage layer (CSI) or on the information storage layer (CSI).

4. Component (CO) according to one of the preceding claims **characterised in that** it comprises a plurality of flat electrodes (EP), a plurality of electrolyte layers (CI) and a plurality of active electrodes (EA), each flat electrode (EP) of the plurality of flat electrodes (EP) being laid out so as to form a memory point (PM) with the vertical pillar (EV); and each active electrode (EA) of the plurality of active electrodes (EA) being separated from a flat electrode (EP) of the plurality of flat electrodes (EP) by an electrolyte layer (CI) of the plurality of electrolyte layers (CI) so as to form an energy storage zone (ZSE).

5. Component (CO) according to the preceding claim **characterised in that** each flat electrode (EP) comprises a third layer (EP3), said third layer (EP3) facing an active electrode (EA) of the plurality of active electrodes (EA), separated from said active electrode (EA) by an electrolyte layer (CI) of the plurality of electrolyte layers (CI) and being constituted of an ion source material, said third layer (EP3), said electrolyte layer (CI) and said active electrode (EA) forming an energy storage zone (ZSE).

6. Component (CO) according to the preceding claim **characterised in that** the first layer (EP1) and/or the third layer (EP3) of each flat electrode (EP) of the plurality of flat electrodes (EP) are not in contact with the vertical pillar (PI).

7. Component (CO) according to claim 4 **characterised in that** the first layer (EP1) and/or the third layer (EP3) of each flat electrode (EP) of the plurality of flat electrodes (EP) are separated from the vertical pillar (PI) by an insulating material.

8. Component (CO) according to one of the preceding claims **characterised in that** the material of the vertical electrode (EV) and the material of the information storage layer (CSI) are chosen so as to form, with the flat electrode (EP) or with each flat electrode (EP) of the plurality of flat electrodes (EP), a phase change memory point (PM) or a resistive memory point (PM).

9. Component (CO) according to one of the preceding claims **characterised in that** it includes a plurality of vertical pillars (PI) each vertical pillar (PI) being laid out so as to form a memory point (PM) with the flat electrode (EP) or with each flat electrode (EP) of the plurality of flat electrodes (EP).

10. Component (CO) according to the preceding claim **characterised in that** the projection of the vertical pillars (PI) of the plurality of vertical pillars (PI) onto a plane parallel to the plane formed by the flat electrode (EP) or to the planes formed by the flat electrodes (EP) of the plurality of flat electrodes (EP) forms an array of which the unit cell is a square cell or a lozenge-shaped cell.

11. Semiconductor device (DI) **characterised in that** it includes a component (CO) according to one of the preceding claims and means so that said component (CO) is used for the storage of information and/or for the storage of energy.

12. Device (DI) according to the preceding claim **characterised in that** it comprises a second component (CO) according to one of claims 1 to 6 and means so that the second component (CO) is used for the storage of information and/or for the storage of energy.

13. Method for using a device (DI) according to the preceding claim **characterised in that** it comprises:
- a step in which at least one among the first or the second semiconductor component (CO) is used for the storage of information;
- a step in which at least one among the first or the second semiconductor component (CO) is used for the storage of energy.

14. Method according to the preceding claim **characterised in that** the energy required for the step of using at least one component (CO) for the storage of information is supplied by the energy stored during the step in which at least one component (CO) is used for the storage of energy.
